# EUROPÄISCHE PATENTSCHRIFT

(11) **EP 2 155 429 B1**
(45) Veröffentlichungstag und Bekanntmachung des Hinweises auf die Patenterteilung: **23.05.2012**
(21) Anmeldenummer: 08757941.3
(22) Anmeldetag: 17.04.2008
(51) Int. Cl.: B23K 1/06

(54) **TRANSFERVORRICHTUNG ZUR AUFNAHME UND ÜBERGABE EINER LOTKUGELANORDNUNG**
TRANSFER DEVICE FOR RECEIVING AND TRANSFERRING A SOLDER BALL ARRANGEMENT
DISPOSITIF DE TRANSFERT CONÇU POUR RECEVOIR ET TRANSFÉRER UN ENSEMBLE DE GLOBULES DE BRASAGE

(30) Priorität: 11.06.2007 DE 102007027291
(43) Veröffentlichungstag der Anmeldung: 24.02.2010
(73) Patentinhaber: Pac Tech - Packaging Technologies GmbH, 14641 Nauen (DE); Smart Pac GmbH Technology Services, 14641 Nauen (DE)
(72) Erfinder: AZDASHT, Ghassem, 13591 Berlin (DE); TABRIZI, Siavash, 14057 Berlin (DE)
(74) Vertreter: von den Steinen, Axel
(86) Internationale Anmeldenummer: PCT/DE2008/000637
(87) Internationale Veröffentlichungsnummer: WO 2008/151588

(56) Entgegenhaltungen:
- WO-A-2006/045266
- US-A- 5 657 528
- US-A- 5 680 984

## Beschreibung

Die Erfindung betrifft eine Transfervorrichtung gemäß dem Oberbegriff des Anspruch 1, zur Aufnahme und Übergabe einer Lotkugelanordnung mit einem Entnahmebehältnis und einem zur Ausbildung einer ebenen Lotkugelanordnung mit dem Entnahmebehältnis zusammenwirkenden und mit Unterdruck beaufschlagbaren Transfersubstrat, wobei das Entnahmebehältnis eine zumindest bereichsweise perforierte Bodenwandung und das Transfersubstrat ein Lochmuster zur Aufnahme der Lotkugelanordnung aufweist.

Eine Vorrichtung der eingangs genannten Art ist aus der DE 10 2004 051 983 A 1 bekannt. Bei der bekannten Vorrichtung ist oberhalb eines Entnahmebehältnisses ein als Lochschablone ausgebildetes Transfersubstrat angeordnet, dass mit einem Vakuum beaufschlagbar ist, um unterhalb des Transfersubstrats in dem Entnahmebehältnis regellos verteilt angeordnete Lotkugeln anzusaugen und für eine Anordnung der Lotkugeln entsprechend dem Lochmuster der Schablone zu sorgen. Um die Wirkung des Unterdrucks zu unterstützen, ist die Bodenwandung des Entnahmebehältnisses mit einer Perforierung versehen. Die flächige unterseitige Einströmung von Luft durch die perforierte Bodenwandung sorgt für eine gleichmäßige Belüftung, so dass durch die Vakuumbeaufschlagung des Transferaubstrats eine flächige Verteilung der Lotkugeln im Entnahmebehältnis nicht nachteilig beeinflusst wird, also beispielsweise keine zentralen Anhäufungen von Lotkugeln im Entnahmebehältnis, die einer gleichmäßigen Besetzung des Transfersubstrats mit Lotkugeln entgegenwirken würden, gebildet werden.

Die bekannte Vorrichtung stellt somit sicher, dass eine zu Beginn der Vakuumbeaufschlagung des Transfersubstrats im Entnahmebehältnis vorliegende Verteilung während der Entnahme von Lotkugeln aus dem Entnahmebehältnis im Wesentlichen beibehalten wird. Dies bedeutet aber auch, dass eine bereits vor Beginn der Vakuumbeaufschlagung, beispielsweise aufgrund eines Befüllungsvorgangs des Entnahmebehältnisses, entstandene ungleichmäßige Verteilung der Lotkugeln im Entnahmebehältnis, die häufig gerade in einem Einfüllbereich lokale Anhäufungen aufweist, aufrecht erhalten wird. Aus diesem Grunde ist es bei der bekannten Vorrichtung nachfolgend einem Befüllungsvorgang des Entnahmebehältnisses zurächst notwendig, eine Nivellierung der im Entnahmebehältnis angeordneten Lotkugelschicht durchzuführen. Hierzu wird beispielsweise eine Nivellierung der Schichtoberfläche der Lotkugelschicht mittels einer Rakeleinrichtung durchgeführt.

Dokument WO 2006/0454266 offenbart eine Transfervorrichtung zur Aufnahme von Lotkugeln mit einem Entnahmebehältnis und einem Transfersubstrat an einer Handhabungseinrichtung. Das Transfersubstrat ist mit einem Unterdruck beaufschlagbar, wobei eine perforierte Bodenwandung des Entnahmebehältnisses eine Belüftung einer Lotkugelschicht ermöglicht. Des Weiteren ist an der Handhabungsvorrichtung eine Ultraschalleinrichtung vorgesehen.

Dokument US 5680984 beschreibt eine ebensolche Transfervorrichtung, bei welcher ein Entnahmebehältnis eine geschlossene Bodenwandung aufweist und insbesondere mit einer Ultraschalleinrichtung versehen ist. Am Entnahmebehältnis ist ein optoelektronischer Sensor vorgesehen, der einen Füllstand kontrollieren und gegebenenfalls ein Auffüllen des Entnahmebehältnisses mit Lotkugeln aus einem Lotkugelreservoir bewirken soll.

Dokument US 5657,528 zeigt eine Transfervorrichtung mit einem Entnahmebehältnis, dessen Bodenwandung perforiert ausgebildet ist. Mittels eines Ventilators wird eine Lotkugelschicht im Entnahmebehältnis über die Bodenwandung mit einem Inertgas beaufschlagt. Weiterhin ist an einer Handhabungsvorrichtung eine Ultraschalleinrichtung und am Entnahmebehältnis ein Vibrator vorgesehen.

Der vorliegenden Erfindung liegt die Aufgabe zugrunde, eine Vorrichtung der eingangs genannten Art vorzuschlagen, die eine Nivellierung der im Entnahmebehältnis angeordneten Lotkugelschicht vereinfacht.

Zur Lösung dieser Aufhabe weist die erfindungsgemäße Transfervorrichtung die Merkmale des Anspruchs 1 auf.

Bei der erfindungsgemäßen Transfervorrichtung ist das Entnahmebehältnis mit einer Ultraschalleinrichtung zur Beaufschlagung des Entnahmebehältnisses mit Ultraschallschwingungen versehen.

Die Beaufschlagung des Entnahmebehältnisses mit Ultraschallschwingungen sorgt dafür, dass etwaige lokale Anhäufungen in der Lotkugelschicht infolge eines Befüllungsvorgangs des Entnahmebehältnisses nicht entstehen bzw. sofort beseitigt werden, so dass eine ebene Schichtoberfläche der Lotkugelschicht gewährleistet ist. Somit kann sichergestellt werden, dass bei einer Vakuumbeaufschlagung der Lotkugelschicht zur Ausbildung einer definierten Lotkugelanordnung auf dem Transfersubstrat eine optimale Verteilung der Lotkugeln im Entnahmebehältnis herrscht, Insbesondere ersetzt die Aktivierung der Ultraschalleinrichtung eine ansonsten entweder manuell oder mit entsprechendem mechanischem Aufwand zu realisierende Rakelfunktion. Weiterhin kann die Ultraschallbeaufschlagung des Entnahmebehältnisses sogar während der Vakuumbeaufschlagung des Transfersubstrats und der Ausbildung einer Lotkugelanordnung auf dem Transfersubstrat erfolgen, ohne diese zu behindern. Vielmehr unterstützt die Ultraschallbeaufschlagung des Entnahmebehältnisses noch die Ausbildung der Lotkugelanordnung auf dem Transfersubstrat.

Bei einer bevorzugten Ausführungsform ist zwischen dem Transfersubstrat und dem Entnahmebehältnis eine Dichtungseinrichtung angeordnet, die ein Entweichen von Lotkugeln aus dem Entnahmebehältnis verhindert.

Wenn unterhalb der Bodenwandung des Entnahmebehältnisses eine Zuführeinrichtung zur Zuführung eines ionisierten Gases, insbesondere Luft, vorgesehen ist, kann einer statischen Aufladung der Lotkugeln im Entnahmebehältnis entgegengewirkt werden.

Erfindungsgemäß ist das Entnahmebehältnis über eine Dosiereinrichtung mit einem Lotkugelreservoir verbunden. Der Anschluss eines Lotkugelreservoirs an das Entnahmebehältnis über eine Dosiereinrichtung ermöglicht eine automatisierte oder selbsttätige Befüllung des Entnahmebehältnisses. Durch die Ultraschallbeaufschlagung des Entnahmebehältnisses ist gleichzeitig sichergestellt, dass unmittelbar nach einer über die Dosiereinrichtung erfolgten Befüllung oder Nachfüllung des Entnahmebehältnisses eine Nivellierung der Füllstandshöhe im Entnahmebebältnis erfolgt.

Erfindungsgemäβ ist zur Ausbildung der Dosiereinrichtung an einer Unterseite des Lotkugelreservoirs ein vermittels einer Ultraschalleinrichtung mit Ultraschallschwingungen beaufschlagbares Ausgabemundstück angeordnet wodurch die Ausbildung. einer "Ventilfunktion" an der Dosiereinrichtung ohne die Verwendung mechanischer, beweglicher Ventilelemente möglich wird. Vielmehr ist die Schließfunktion des "Ventils" dadurch bewirkt, dass sich bei einer nicht erfolgenden Ultraschallbeaufschlagung des Ausgabemundstücks die Lotkugeln im Ausgabekanal des Ausgabemundstücks gegeneinander verkeilen, so dass der Durchgang durch das Ausgabemundstück versperrt ist. Eine Beaufschlagung des Ausgabemundstücks mit Ultraschallschwingungen sorgt dafür, dass die im Ausgabekanal gegeneinanderliegenden Lotkugeln schwingungsinduziert aufeinander gleiten und so die Blockade im Ausgabekanal unter Ultraschallbeaufschlagung gelöst wird und ein Nachströmen von oberhalb des Ausgabemundstücks im Lotkugelreservoir angeordneten Lotkugeln durch das Ausgabemundstück erfolgen kann.

Die Beaufschlagung des Ausgabemundstücke kann unmittelbar durch direkte Einwirkung der Ultraschalleinrichtung auf das Ausgabemundstück oder mittelbar durch Einwirkung der Ultraschalleinrichtung auf andere Bereiche oder Teile des Lotkugelreservoirs erfolgen.

Wenn die Dosiereinrichtung über eine flexible Zuführung mit dem Entnahmebehältnis verbunden ist, kann bei Bedarf die Ultraschallbeaufschlagung des Ausgabemundstücks entkoppelt von der Ultraschallbeaufschlagung des Entnahmebehältnisses erfolgen bzw. umgekehrt. Natürlich ist es abweichend hiervon auch möglich, die Ultraschallbeaufschlagung des Entnahmebehältnisses gleichzeitig mit der Ultraschallbeaufschlagung des Ausgabemundstücks durohzuführen.

Insbesondere um die Öffnung des durch das Ausgabemundstück definierten "Ventils" zu unterstützen, kann das Lotkugelreservoir mit einer Vakuumeinrichtung zur Beaufschlagung des Lotkugelreservoirs mit einem Vakuum versehen sein.

Zur Unterstützung einer automatischen bzw. selbsttätigen Befüllung des Entnahmebehältnisses mit Lotkugeln aus dem Lotkugelreservoir ist es vorteilhaft, wenn das Entnahmebehältnis mit einer Sensoreinrichtung zur Überwachung des Füllstands versehen ist, die mit der Dosiereinrichtung zusammenwirkt und somit bei Bedarf für eine Aktivierung der Dosiereinrichtung bzw. ein Öffnen des als "Ventil" wirkenden Ausgabemundstücks sorgt.

Besonders kostengünstig ist es, wenn zur Ausbildung der Sensoreinrichtung am Entnahmebehältnis in Füllstandshöhe eine Lichtschrankeneinrichtung angeordnet ist.

Vorteilhaft hinsichtlich eines besonders einfachen Aufbaus des Entnahmebehältnisses ist es, wenn das Entnahmebehältnis eine ringförmige Umfangswandung aufweist, die mit der perforierten Bodenwandung versehen ist.

Eine besonders funktionssichere und kostengünstige Ausgestaltung des Entnahmebehältnisses ist möglich, wenn die perforierte Bodenwandung aus einem Drahtgewebe gebildet ist.

Eine besonders einfache Realisierung der Dichtungseinrichtung ist gegeben, wenn diese als Dichtring ausgebildet ist, der zwischen der Umfangswandung und dem Transfersubstrat angeordnet ist; insbesondere bei Anordnung auf der Stirnfläche der Umfangswandung.

Nachfolgend wird eine Ausführungsform der Transfervorrichtung anhand der Zeichnung näher erläutert.

Es zeigen:
- **Fig. 1**: eine schematische Darstellung einer Transfervorrichtung mit einem innerhalb eines Entnahmebehältnisses angeordneten Transfersubstrat;
- **Fig. 2**: das in **Fig. 1** dargestellte Entnahmebehältnis in einer Schnittansicht gemäß Schnittlinienverlauf II-II in **Fig 1****;**.
- **Fig. 3**: eine weitere Ausführungsform eines Entnahmebehältnisses;
- **Fig. 4**: das in **Fig. 3** dargestellte Entnahmebehältnis in einer Schnittansicht gemäß Schnittlinienverlauf IV-IV in **Fig. 3** mit einem an das Entnahmebehältnis angeschlossenen Lotkugelreservoir;
- **Fig. 5**: das in **Fig. 4** dargestellte Entnahmebehältnis mit einem auf dem Entnahmebehältinis angeordneten Transfersubstrat.

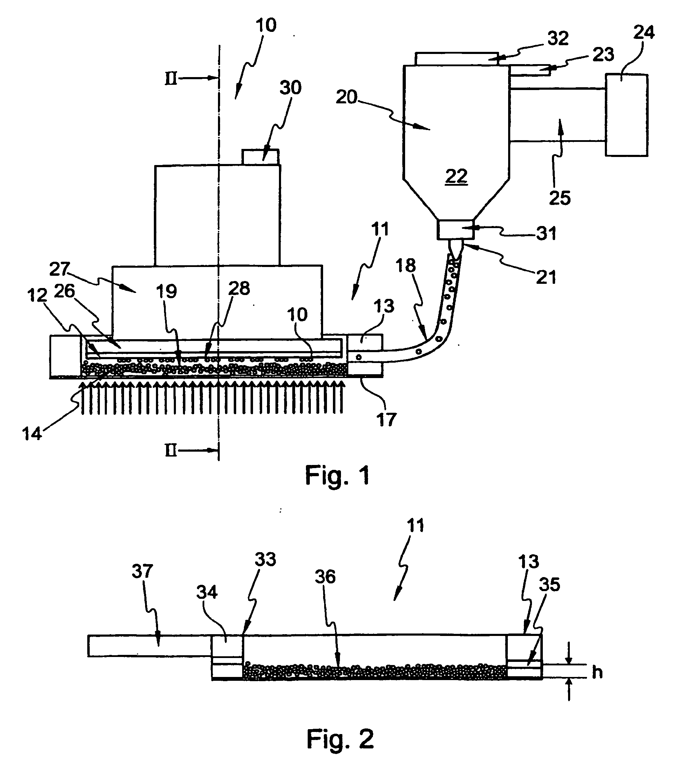

**Fig. 1** zeigt eine Transfervorrichtung 10 mit einem in einem Entnahmebehältnis 11 angeordneten Transfersubstrat 12. Das Entnahmebehältnis 11 weist eine ringförmig ausgebildete Umfangswandung 13 mit einer den unteren stirnseitigen Abschluss der Umfangswandung 13 bildenden Bodenwandung 14 auf. Die Bodenwandung 14 ist bei dem vorliegenden Ausführungsbeispiel aus einem netzartigen Drahtgewebe gebildet, das eine Maschenweite aufweist, die zumindest geringfügig kleiner ist als der Durchmesser von im Entnahmebehältnis 11 angeordneten Lotkugeln 16, die in ihrer Gesamtheit eine Lotkugelschicht 17 im Entnahmebehältnis 11 bilden.

Über eine hier elastisch ausgeführte Zuführleitung 18 ist ein Lotkugelaufnahmeraum 19, in dem sich die Lotkugelschicht 17 befindet, mit einem einen Vorratsspeicher bildenden Lotkugelreservoir 20 verbunden. An der Unterseite des Lotkugelreservoirs 20 ist als Schnittstelle zur Zuführleitung 18 ein Ausgabemundstück 21 angeordnet. Ein im Inneren des Lotkugelreservoirs 20 ausgebildeter Lotkugelspeicherraum 22 ist über einen Vakuumanschluss 23 mit einer hier nicht näher dargestellten Vakuumeinrichtung verbunden. Der Anschluss des Lotkugelreservoirs 20 an ein Gestell 24 erfolgt über eine Wägeeinrichtung 25, die bei Bedarf einen Nachfüllvorgang des Lotkugelreservoirs 20 auslösen kann.

Das in **Fig. 1** innerhalb des Lotkugelaufnahmeraums 19 angeordnete Transfersubstrat 12 ist an einer Unterseite einer Anschlusseinrichtung 26 einer Handhabungseinrichtung 27 angeordnet. Die Handhabungsvorrichtung 27 bzw. eine die Handhabungsvorrichtung 27 aufnehmende Haltevorrichtung ist mit einer Vakuumeinrichtung bzw. einem Vakuumanschluss 30 versehen, der durch ein im Transfersubstrat 12 ausgebildetes, hier nicht näher dargestelltes Lochmuster hindurch eine rückwärtige Beaufschlagung des Lotkugelaufnahmeraums 19 des Entnahmebehältnisses 11 mit einem Vakuum ermöglicht. Die Handhabungseinrichtung 27 dient zur Ausführung von räumlichen Zustellbewegungen des Transfersubstrats 12, so dass das Transfersubstrat 12 zum einen zur Entnahme einer Lotkugelanordnung 28 aus dem Entnahmebehältnis 11 in die in **Fig. 1** dargestellte Entnahmeposition überführbar ist, und zum anderen eine Überführung der auf dem Transfersubstrat 12 angeordneten Lotkugelanordnung 28 in eine hier nicht näher dargestellte Kontaktierungsposition ermöglicht wird, in der sich die Lotkugelanordnung 28 in einer Überdeckung mit Kontaktstellen eines Kontaktsubstrats befindet. Um ausgehend von der Positionierung der Lotkugelanordnung 28 in einer Kontaktierungsposition unmittelbar nachfolgend die thermische Kontaktierung der Lotkugelanordnung 28 mit dem Kontaktsubstrat durchführen zu können, kann die Handhabungseinrichtung 27 auch als sogenannter "Bondkopf" ausgeführt sein, der eine thermische Beaufschlagung der Lotkugeln ermöglicht.

Im Betrieb der in **Fig. 1** dargestellten Transfervorrichtung erfolgt nachfolgend einer Positionierung des Transfersubstrats 12 im Lotkugelaufnahmeraum 19 des Entnahmebehältnisses 11 eine Beaufschlagung des Lotkugelaufnahmeraums 19 mit einem am Vakuumanschluss 30 anliegenden Vakuum. Aufgrund der durch die perforierte Bodenwandung 14 des Entnahmebehältnisses 11 erfolgenden Belüftung 30 werden im Zusammenwirken mit dem Vakuum vereinzelte Lotkugeln 16 aus der Lotkugelschicht 17 zur Ausbildung der in **Fig. 1** dargestellten Lotkugelanordnung 28 in dem im Transfersubstrat 12 ausgebildeten Lochmuster überführt. Dabei kann die Ausbildung der Lotkugelanordnung 28 noch durch eine Ultraschallbeaufschlagung der das Transfersubstrat 12 aufnehmenden Anschlusseinrichtung 26 unterstützt werden.

Um für eine ausreichende Befüllung des Lotkugelaufnahmeraums 19 zu sorgen, erfolgt im Bedarfsfall über die Zuführung 18 eine Auffüllung des Lotkugelaufnahmeraums 19 mit Lotkugeln 16 aus dem Lotkugelreservoir 20. Eine dem Bedarf entsprechende Dosierung der Zufuhr von Lotkugeln 16 aus dem Lotkugelreservoir 20 erfolgt vermittels einer Dosiereinrichtung 31, die im Übergangsbereich zwischen der Zuführung 18 und dem Lotkugelreservoir 20 angeordnet ist. Die Dosiereinrichtung 31 besteht im Wesentlichen aus dem Ausgabemundstück 21 und einer das Ausgabemundstück 21 beaufschlagenden Ultraschalleinrichtung 32. Bei dem in **Fig. 1** dargestellten Ausführungsbeispiel befindet sich die Ultraschalleinrichtung 32 am oberen Ende des Lotkugelreservoirs 20. Es ist jedoch auch möglich, die Ultraschalleinrichtung beispielsweise unmittelbar am Ausgabemundstück 21 anzuordnen.

Zur Auslösung bzw. Steuerung der Dosiereinrichtung 31 ist, wie in **Fig. 2** dargestellt, das Entnahmebehältnis 11 mit einer Lichtschrankeneinrichtung 33 versehen, die im Falle des vorliegenden Ausführungsbeispiels einen Sender 34 und einen Empfänger 35 aufweist, die jeweils an einander gegenüberliegenden Stellen in der Umfangswandung 13 des Entnahmebehältnisses 11 angeordnet sind. Wenn die im Lotkugelaufnahmeraum 19 des Entnahmebehältnisses 11 ausgebildete Lotkugelschicht 17 eine durch die Lichtschrankeneinrichtung 33 definierte Füllstandshöhe h unterschreitet, wird zwischen dem Sender 34 und dem Empfänger 35 ein Kontakt ausgelöst, der die Dosiereinrichtung 31 in Betrieb setzt. Zur Sicherstellung einer im Wesentlichen plan- oder bodenwandungsparallelen Schichtoberfläche 36 ist an der Umfangswandung 13 eine Ultraschalleinrichtung 37 vorgesehen, die das Entnahmebehältnis 11 mit Ultraschallschwingungen beaufschlagt und so für eine im Wesentlichen gleichmäßige Verteilung der Lotkugeln 16, also eine im Wesentlichen zur Bodenwandung 14 parallele Schichtoberfläche 36 der Lotkugelschicht 17, sorgt.

Die Auslösung der Dosiereinrichtung 31 erfolgt über eine Aktivierung der Ultraschalleinrichtung 32, die das Ausgabemundstück 21 mit Ultraschallschwingungen beaufschlagt. Das Ausgabemundstück 21 weist einen hier nicht näher dargestellten Ausgabekanal auf, dessen Öffnungsquerschnitt so bemessen ist, dass im Zusammenwirken mit Umgebungsparametern ein Verkeilen der Lotkugeln 16 im Öffnungsquerschnitt erfolgen kann. Das Auftreten des Verkeilungseffekts ist beispielsweise von der Luftfeuchtigkeit und der Sauerstoffzufuhr im Lotkugelreservoir 20 abhängig. Durch eine Stickstoffströmung im Lotkugelreservoir 20 und/oder im Ausgabekanal kann die Sauerstoffzufuhr vermindert und die Luftfeuchtigkeit beeinflusst, insbesondere konstant gehalten, werden, um die Verkeilung effektiv zu erhöhen. Weiterhin kann durch Austauschen des Mundstücks 21 der Öffnungsquerschnitt des Ausgabekanals einfach an unterschiedliche Lotkugeldurchmesser angepasst werden, um den Ventileffekt für unterschiedliche Lotkugeldurchmesser zu erreichen.

Die Ultraschallbeaufschlagung des Ausgabemundstücks 21 bewirkt, dass im Ausgabekanal des Ausgabemundstücks 21 verkeilt gegeneinander angeordnete Lotkugeln 16 in eine vibrationsinduzierte Relativbewegung versetzt werden, die die Fixierung der Lotkugeln 16 im Ausgabekanal löst und ein Ausströmen von im Lotkugelreservoir angeordneten Lotkugeln 16 durch das Mundstück 21 und die Zuführung 18 in den Lotkugelaufnahmeraum 19 des Entnahmebehältnisses 11 ermöglicht. Sobald die Ultraschalleinrichtung 32 wieder außer Betrieb gesetzt wird, kommt es wieder zur gegenseitigen Fixierung der Lotkugeln 16 im Ausgabekanal des Ausgabemundstücks 21, der in seinem Durchmesser gerade so bemessen ist, dass ein derartiges Verkeilen erfolgen kann.

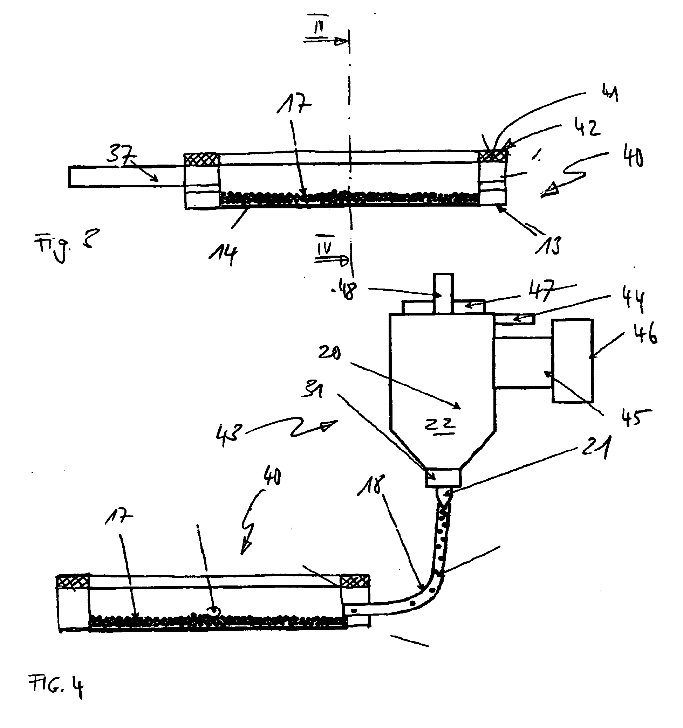

**Fig. 3** zeigt ein Entnahmebehältnis 40, das in Übereinstimmung mit dem in **Fig. 2** dargestellten Entnahmebehältnis 11 mit einer ringförmig ausgebildeten Umfangswandung 13 versehen ist, die eine den unteren stirnseitigen Abschluss der Umfangswandung 13 bildende Bodenwandung 14 aufweist, auf der eine Lotkugelschicht 17 angeordnet ist. Ebenfalls in Übereinstimmung mit dem in **Fig. 2** dargestellten Entnahmebehältnis 11 weist das Entnahmebehältnis 40 an der Umfangswandung 13 eine Ultraschalleinrichtung 37 auf, die eine Ultraschallbeaufschlagung des Entnahmebehältinisses 40 ermöglicht.

Im Unterschied zu dem in **Fig. 2** dargestellten Entnahmebehältnis 11 ist die Umfangswandung 13 auf ihrer oberen Stirnfläche 41 mit einem im vorliegenden Fall aus einem elastischen Material gebildeten Dichtring 42 versehen.

**Fig. 4** zeigt das in **Fig. 3** dargestellte Entnahmebehältnis 40, an das über eine hier elastisch ausgeführte Zuführleitung 18 ein Lotkugelreservoir 43 angeschlossen ist. Das Lotkugelreservoir 43 weist in Übereinstimmung mit dem Lotkugelreservoir 20 einen Lotkugelspeicherraum 22 auf, der mit einer Stickstoffzuführung 44 versehen ist. Im Unterschied zum Lotkugelreservoir 20 wird das Lotkugelreservoir 43 mittelbar über eine Halterung 45 vermittels einer Ultraschalleinrichtung 46 mit Schwingungen beaufschlagt, um die bereits im Zusammenhang mit der **Fig. 1** beschriebene Ultraschallbeaufschlagung des Ausgabemundstücks 21, das mit der Dosiereinrichtung 31 verbunden ist, zu bewirken.

Das Lotkugelreservoir 43 ist an seiner Oberseite mit einer eine Befüllung ermöglichenden Deckeleinrichtung 47 versehen, welche einen Füllstandssensor 48 aufweist, der bei Unterschreitung einer vorgegebenen Füllstandshöhe des Lotkugelreservoirs 43 eine Nachbefüllung desselben bzw. eine auf die Notwendigkeit einer Nachbefüllung hinweisende Anzeige bewirkt.

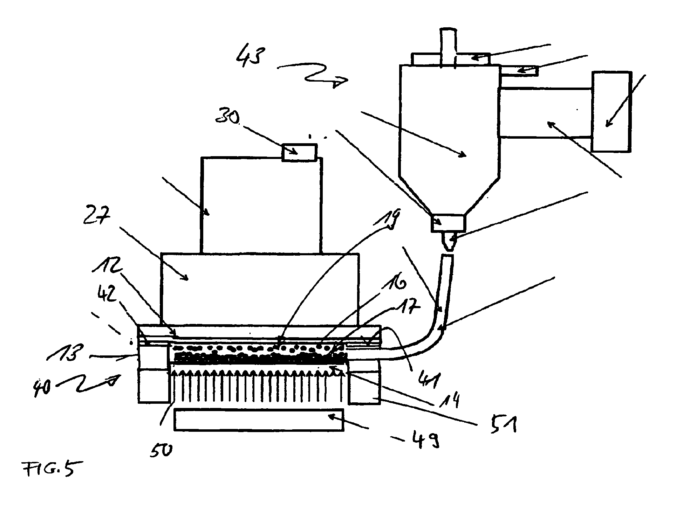

**Fig. 5** zeigt das Entnahmebehältnis 40 in Kombination mit einem Transfersubstrat 12, um eine Entnahme einer Lotkugelanordnung 28 aus einem Lotkugelaufnahmeraum 19 des Entnahmebehältnisses 40 zu ermöglichen.

Wie bereits unter Bezugnahme auf **Fig. 1** beschrieben, erfolgt die Entnahme der Lotkugelanordnung 28 aus dem Entnahmebehältnis 40 durch eine Vakuumbeaufschlagung der Lotkugelschicht 17 vermittels eines am Vakuumanschluss 30 anliegenden Unterdrucks, so dass die Lotkugeln 16 gegen das Transfersubstrat 12 gesaugt werden und dabei vermittels des Lochmusters des Transfersubstrats 12 entsprechend der gewünschten Lotkugelanordnung 28 (**Fig. 1**) ausgerichtet werden.

Wie **Fig. 5** zeigt, ist während der Unterdruckbeaufschlagung der Lotkugelschicht 17 das Transfersubstrat 12 zur Erzielung einer Abdichtung gegen die Stirnfläche 41 der Umfangswandung 13 des Entnahmebehältnisses 40 verfahren, wobei sich die Umfangswandung 13 an einer Halterung 51 abstützt und der Dichtring 42 mehr oder weniger komprimiert wird. Durch die Abdichtung wird einerseits die Effektivität des über den Vakuumanschluss 30 angelegten Unterdrucks erhöht, zum anderen wird verhindert, dass Lotkugeln 16 aus dem Lotkugelaufnahmeraum 19 am Transfersubstrat 12 vorbei nach außerhalb des Entnahmebehältnisses 40 gelangen. Insbesondere, wenn, wie im Falle der in **Fig. 5** dargestellten Ausführungsform, während der Unterdruckbeaufschlagung der Lotkugelschicht 17 im Lotkugelaufnahmeraum 19 vermittels einer Zuführeinrichtung 49 durch die Bodenwandung 14 eine ionisierte Luftströmung 50 in den Lotkugelaufnahmeraum 19 eingeleitet wird, wird somit wirksam verhindert, dass Lotkugeln 16 unkontrolliert aus dem Lotkugelaufnahmeraum 19 entweichen können. Gleichzeitig wird verhindert, dass Umgebungsluft durch einen zwischen der Stirnfläche 41 der Umfangswandung 13 und dem Transfersubstrat 12 ausgebildeten Spalt in den Lotkugelaufnahmeraum 19 gelangen könnte und so die vorteilhafte antistatische Wirkung der ionisierten Luftströmung 49 zumindest teilweise aufheben oder schwächen könnte.

Da die in den Figuren dargestellte Transfervorrichtung 10 vor allem zur Kontaktierung der aufgenommenen Lotkugelanordnung 28 mit entsprechend der Lotkugelanordnung positionierten Chipkontakten eines Wafers dient, ist es vorteilhaft, dass sowohl das Entnahmebehältnis 11 als auch das Entnahmebehältnis 40 vermittels einer entsprechenden Dimensionierung der ringförmig ausgebildeten Umfangswandung 13 leicht an unterschiedliche Wafergrößen angepasst werden können. Dabei kann unabhängig von der Wafergröße mit einem identisch ausgebildeten Transfersubstrat 12 gearbeitet werden, da bei dem in **Fig. 5** dargestellten Ausführungsbeispiel das Transfersubstrat 12 mit zwischenliegender Anordnung des Dichtrings 42 gegen das Entnahmebehältnis 40 anliegt und somit die Flächenausdehnung der Lötkugelanordnung 28 auf dem Transfersubstrat , 12 bestimmt.

## Patentansprüche

1. Transfervorrichtung (10) zur Aufnahme und Übergabe einer Lotkugelanordnung (28) mit einem Entnahmebehältnis (11) und einem zur Ausbildung einer ebenen Lotkugelanordnung mit dem Entnahmebehältnis zusammenwirkenden und mit Unterdruck beaufschlagbaren Transfersubstrat (12), wobei das Entnahmebehältnis eine zumindest bereichsweise perforierte Bodenwandung (14) und das Transfersubstrat ein Lochmuster zur Aufnahme der Lotkugelanordnung aufweist, wobei das Entnahmebehältnis mit einer Ultraschalleinrichtung (37) zur Beaufschlagung des Entnahmebehältnisses mit Ultraschallschwingungen versehen ist, und wobei das Entnahmebehältnis (11, 40) über eine Dosiereinrichtung (31) mit einem Lotkugelreservoir (20, 43) verbunden ist,
**dadurch gekennzeichnet,**
**dass** zur Ausbildung der Dosiereinrichtung (31) an einer Unterseite des Lotkugelreservoirs (20, 43) ein vermittels einer Ultraschalleinrichtung (32, 46) mit Ultraschallschwingungen beaufschlagbares Ausgabemundstück (21) angeordnet ist.

2. Transfervorrichtung nach Anspruch 1,
**dadurch gekennzeichnet,**
**dass** zwischen dem Transfersubstrat (12) und dem Entnahmebehältnis (40) eine Dichtungseinrichtung angeordnet ist.

3. Transfervorrichtung nach Anspruch 1 oder 2,
**dadurch gekennzeichnet,**
**dass** dem Entnahmebehältnis (40) unterhalb der Bodenwandung (14) eine Zuführeinrichtung (49) zur Zuführung eines ionisierten Gases (50) zugeordnet ist.

4. Transfervorrichtung nach einem der vorangehenden Ansprüche,
**dadurch gekennzeichnet,**
**dass** die Dosiereinrichtung (31) über eine flexible Zuführung (18) mit dem Entnahmebehältnis (11, 40) verbunden ist.

5. Transfervorrichtung nach einem der vorangehenden Ansprüche,
**dadurch gekennzeichnet,**
**dass** das Lotkugelreservoir (20, 43) mit einer Vakuumeinrichtung zur Beaufschlagung des Lotkugelreservoirs mit einem Vakuum versehen ist.

6. Transfervorrichtung nach einem der vorangehenden Ansprüche,
**dadurch gekennzeichnet,**
**dass** das Entnahmebehältnis (11, 40) mit einer Sensoreinrichtung zur Überwachung der Füllstandshöhe h versehen ist, die mit der Dosiereinrichtung (31) zusammenwirkt.

7. Transfervorrichtung nach Anspruch 6,
**dadurch gekennzeichnet,**
**dass** zur Ausbildung der Sensoreinrichtung am Entnahmebehältnis (11, 40) in Füllstandshöhe h eine Lichtschrankeneinrichtung (33) angeordnet ist.

8. Transfervorrichtung nach einem der vorangehenden Ansprüche,
**dadurch gekennzeichnet,**
**dass** das Entnahmebehältnis (11, 40) als eine ringförmige Umfangswandung (13) mit perforierter Bodenwandung (14) ausgebildet ist.

9. Transfervorrichtung nach Anspruch 8,
**dadurch gekennzeichnet,**
**dass** die Bodenwandung (14) als Drahtgewebe ausgebildet ist.

10. Transfervorrichtung nach Anspruch 8 oder 9,
**dadurch gekennzeichnet,**
**dass** die Dichtungseinrichtung als Dichtring (42) ausgebildet ist, der zwischen der Umfangswandung (13) und dem Transfersubstrat (12) angeordnet ist.

11. Transfervorrichtung nach Anspruch 10,
**dadurch gekennzeichnet,**
**dass** der Dichtring (42) auf einer dem Transfersubstrat (12) zugewandten Stirnfläche (41) der Umfangswandung (13) angeordnet ist.

## Claims

1. Transfer device (10) for receiving and transferring a solder ball arrangement (28), comprising a discharge container (11) and a transfer substrate (12) that interacts with the discharge container in order to obtain a flat solder ball arrangement and that can be subjected to a negative pressure, wherein the discharge container comprises an at least partially perforated base wall (14) and the transfer substrate has a hole pattern for receiving the solder ball arrangement, wherein the discharge container is provided with an ultrasound device (37) for subjecting said discharge container to ultrasound vibrations, and wherein the discharge container (11, 40) is connected to a solder ball reservoir (20, 43) via a metering device (31),
**characterized in that**
an outlet nozzle (21) that can be subjected to ultrasound vibrations by means of an ultrasound device (32, 46) is disposed on a lower surface of the solder ball reservoir (20, 43) in order to obtain the metering device (31).

2. Transfer device according to claim 1,
**characterized in that**
a sealing device is interposed between the transfer substrate (12) and the discharge container (40).

3. Transfer device according to claim 1 or 2,
**characterized in that**
a supply device (49) for supplying an ionized gas (50) is assigned to the discharge container (40) below the base wall (14).

4. Transfer device according to any of the preceding claims,
**characterized in that**
the metering device (31) is connected to the discharge container (11, 40) via a flexible feeding pipe (18).

5. Transfer device according to any of the preceding claims,
**characterized in that**
the solder ball reservoir (20, 43) is equipped with a vacuum device for subjecting the solder ball reservoir to a vacuum.

6. Transfer device according to any of the preceding claims,
**characterized in that**
the discharge container (11, 40) is equipped with a sensor device that interacts with the metering device (31) for monitoring the filling level h.

7. Transfer device according to claim 6,
**characterized in that**
a photoelectric barrier device (33) is disposed at the discharge container (11, 40) at the height of the filling level h in order to obtain the sensor device.

8. Transfer device according to any of the preceding claims,
**characterized in that**
the discharge container (11, 40) is designed as an annular peripheral wall (13) comprising a perforated base wall (14).

9. Transfer device according to claim 8,
**characterized in that**
the base wall (14) is designed as a wire mesh.

10. Transfer device according to claim 8 or 9,
**characterized in that**
the sealing device is designed as a sealing ring (42) that is interposed between the peripheral wall (13) and the transfer substrate (12).

11. Transfer device according to claim 10,
**characterized in that**
the sealing ring (42) is disposed on a frontal surface (41) of the peripheral wall (13) facing the transfer substrate (12).

## Revendications

1. Dispositif de transfert (10) pour recevoir et transférer un agencement de billes de brasage (28), comprenant un récipient de décharge (11) et un substrat de transfert (12) interagissant avec le récipient de décharge afin d'obtenir un agencement de billes de brasage plat et pouvant être soumis à une pression négative, le récipient de décharge comprenant une paroi de fond (14) étant au moins partiellement perforée et le substrat de transfert présentant un perçage pour recevoir l'agencement de billes de brasage, le récipient de décharge étant muni d'un dispositif à ultrasons (37) pour la soumise dudit récipient de décharge à des vibrations ultrasonores, et le récipient de décharge (11, 40) étant relié avec un réservoir de billes de brasage (20, 43) via un dispositif de dosage (31),
**caractérisé en ce que**
une buse de sortie (21) qui peut être soumise à des vibrations ultrasonores au moyen d'un dispositif à ultrasons (32, 46) est disposée sur une surface inférieure du réservoir de billes de brasage (20, 43) afin d'obtenir le dispositif de dosage (31).

2. Dispositif de transfert selon la revendication 1,
**caractérisé en ce qu'**
un dispositif d'étanchéité est interposé entre le substrat de transfert (12) et le récipient de décharge (40).

3. Dispositif de transfert selon la revendication 1 ou 2,
**caractérisé en ce qu'**
un dispositif d'alimentation (49) pour fournir un gaz ionisé (50) est associé au récipient de décharge (40) au-dessous de la paroi de fond (14).

4. Dispositif de transfert selon l'une quelconque des revendications précédentes,
**caractérisé en ce que**
le dispositif de dosage (31) est relié avec le récipient de décharge (11, 40) via un tube d'alimentation flexible (18).

5. Dispositif de transfert selon l'une quelconque des revendications précédentes,
**caractérisé en ce que**
le réservoir de billes de brasage (20, 43) est équipé d'un dispositif à vide pour la soumise du réservoir de billes de brasage à un vide.

6. Dispositif de transfert selon l'une quelconque des revendications précédentes,
**caractérisé en ce que**
le récipient de décharge (11, 40) est équipé d'un dispositif à capteur interagissant avec le dispositif de dosage (31) pour surveiller le niveau de remplissage h.

7. Dispositif de transfert selon la revendication 6,
**caractérisé en ce qu'**
un dispositif de barrage photo-électrique est disposé au récipient de décharge (11, 40) à la hauteur du niveau de remplissage h afin d'obtenir le dispositif à capteur.

8. Dispositif de transfert selon l'une quelconque des revendications précédentes,
**caractérisé en ce que**
le récipient de décharge (13) est façonné en tant que paroi périphérique annulaire (13) comprenant une paroi de fond perforée (14).

9. Dispositif de transfert selon la revendication 8,
**caractérisé en ce que**
la paroi de fond (14) est façonnée en tant que treillis métallique.

10. Dispositif de transfert selon les revendications 8 ou 9,
**caractérisé en ce que**
le dispositif d'étanchéité est façonné en tant que bague d'étanchéité (42) étant interposée entre la paroi périphérique (13) et le substrat de transfert (12).

11. Dispositif de transfert selon la revendication 10,
**caractérisé en ce que**
la bague d'étanchéité (42) est disposée sur une surface frontale (41) de la paroi périphérique (13) faisant face au substrat de transfert (12).
